# EUROPEAN PATENT APPLICATION

(11) **EP 4 620 900 A1**
(43) Date of publication of application: **24.09.2025**
(21) Application number: 24830056.8
(22) Date of filing: 09.04.2024
(51) Int. Cl.: B81C 1/00, B81B 7/02

(54) **MEMS DEVICE AND MANUFACTURING METHOD THEREFOR**

(30) Priority: 29.06.2023 CN 202310789202
(71) Applicant: United Nova Technology Co., Ltd., Shaoxing, Zhejiang 312000 (CN)
(72) Inventor: ZHANG, Zhaolin, Shaoxing, Zhejiang 312000 (CN)
(74) Representative: Kraus & Lederer PartGmbB
(86) International application number: PCT/CN2024/086720
(87) International publication number: WO 2025/001406

(57) **Abstract**

The present invention provides a MEMS device and a manufacturing method of the same. The method for manufacturing a MEMS device includes: forming a first MEMS structure and a second MEMS structure on a first surface of a second substrate (31), where a first substrate (21) includes a first region corresponding to the first MEMS structure and a second region corresponding to the second MEMS structure; sequentially forming a sacrificial layer (22) and a protective layer (23) on a first surface of the first substrate (21); forming a first cavity (211) and a first evacuation hole (213) in first region and a second cavity (212) in the second region; bonding a second surface of the first substrate (21) to the first surface of the second substrate (31); forming multiple second evacuation holes (231) in the protective layer (23), and forming a third cavity (221) in the sacrificial layer (22), where the second evacuation holes (231) are in communication with third cavity (221); and evacuating the first cavity (211) through the second evacuation holes (231), the third cavity (221), and the first evacuation hole (213), and filling a metal layer in the second evacuation hole (231). **In** the technical solution of the present invention, an evacuation hole can be sealed with no need of a laser sealing process, to solve the problem existing in sealing of the large-size evacuation hole, with a reduced cost.

## Description

### TECHNICAL FIELD

The present invention relates to the technical field of semiconductors, and in particular to a MEMS device and a manufacturing method of the same.

### BACKGROUND

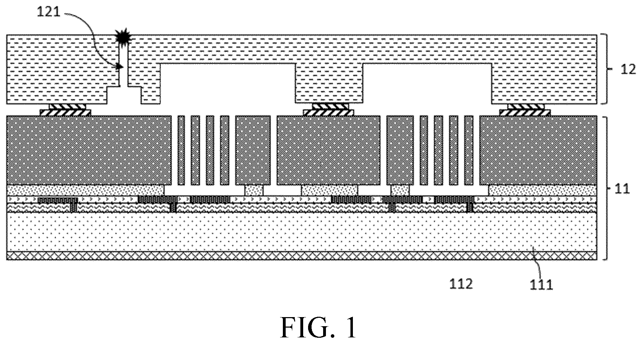

To integrate different MEMS devices (such as an accelerometer and a gyroscope) with different vacuum levels in a same wafer, as shown in Fig. 1, a first substrate 11 is bonded to a second substrate 12, and a vacuum level in a certain MEMS device is adjusted during the bonding process. Moreover, an evacuation hole 121 is etched in the second substrate 12, and a vacuum level in a cavity in communication with the evacuation hole 121 is increased by evacuation via the evacuation hole 121. That is, the vacuum level in a remaining MEMS device is adjusted via the evacuation hole 121. After the vacuum level meets the requirement, the evacuation hole 121 is sealed one-by-one by a special machine using a laser sealing process.

However, when a thickness of the second substrate 12 is large, the etched evacuation hole 121 in the second substrate 12 has a large width due to limited performance of the etching process. As a result, the sealing of the evacuation hole 121 by the laser sealing process has a poor effect or even impossible. In addition, the special machine used for the laser sealing process is expensive, and the sealing efficiency is low due to one-by-one sealing of the evacuation hole 121 during operation, leading to a very high cost.

Therefore, there is a need to improve the sealing process of the evacuation hole, to avoid the above problems.

### SUMMARY

An object of the present invention is to provide a MEMS device and a manufacturing method of the same. In the present invention, an evacuation hole can be sealed with no need of a laser sealing process, to solve the problem existing in sealing of the large-size evacuation hole, with a reduced cost.

To achieve the above object, the present invention provides a method for manufacturing a MEMS device, which includes:
providing a first substrate and a second substrate, where the second substrate is formed with a first MEMS structure and a second MEMS structure on a first surface, and the first substrate includes a first region corresponding to the first MEMS structure and a second region corresponding to the second MEMS structure;
sequentially forming a sacrificial layer and a protective layer that cover a first surface of the first substrate, where the protective layer covers the sacrificial layer;
etching a second surface of the first substrate, to form a first cavity and a first evacuation hole in the first region and a second cavity in the second region, where the first evacuation hole exposes the sacrificial layer;
bonding the second surface of the first substrate to the first surface of the second substrate, where the first evacuation hole is in communication with the first cavity after bonding;
forming multiple second evacuation holes in the protective layer; before the second surface of the first substrate is bonded to the first surface of the second substrate, releasing part of the sacrificial layer through the first evacuation hole, to form a third cavity in the sacrificial layer; or after the multiple second evacuation holes are formed in the protective layer, releasing part of the sacrificial layer through the second evacuation holes, to form a third cavity in the sacrificial layer, where the second evacuation holes are in communication with the third cavity; and
evacuating the first cavity through the second evacuation holes, the third cavity, and the first evacuation hole, and filling a metal layer in the second evacuation hole.

Optionally, the first evacuation hole is staggered from the second evacuation hole in position.

Optionally, a width of the second evacuation hole is less than a width of the first evacuation hole.

Optionally, the width of the first evacuation hole is 10 µm-20 µm, and the width of the second evacuation hole is 1 µm-5 µm.

Optionally, the first region is also formed with a fourth cavity; and the step of forming the first cavity, the first evacuation hole and the fourth cavity in the first region and forming the second cavity in the second region includes:
etching the second surface of the first substrate, to form the first cavity and the fourth cavity in the first region, and form the second cavity in the second region; and
etching a bottom wall of the fourth cavity, to form the first evacuation hole in the bottom wall of the fourth cavity.

Optionally, before the second surface of the first substrate is etched, the method for manufacturing a MEMS device further includes:
forming a first bonding ring on the second surface of the first substrate;
before the second surface of the first substrate is bonded to the first surface of the second substrate, the method for manufacturing a MEMS device further includes:
   forming a second bonding ring on the first surface of the second substrate; and
   the bonding of the second surface of the first substrate to the first surface of the second substrate includes: bonding the second surface of the first substrate to the first surface of the second substrate through the first bonding ring and the second bonding ring.

Optionally, the first MEMS structure includes a comb structure of a gyroscope, and the second MEMS structure includes a comb structure of an accelerometer.

The present invention further provides MEMS device, which includes:
a second substrate, where the second substrate is formed with a first MEMS structure and a second MEMS structure on a first surface; and
a first substrate, where a second surface of the first substrate is bonded to the first surface of the second substrate. The first substrate includes a first region corresponding to the first MEMS structure and a second region corresponding to the second MEMS structure, the first region is formed with a first cavity and a first evacuation hole, and the second region is formed with a second cavity. The first surface of the first substrate is covered with a sacrificial layer and a protective layer, where the protective layer covers the sacrificial layer. A third cavity is formed in the sacrificial layer, multiple second evacuation holes are formed in the protective layer, the first evacuation hole is in communication with the first cavity and the third cavity respectively, and the third cavity is in communication with the second evacuation hole. The second evacuation hole is filled with a metal layer.

Optionally, the first evacuation hole is staggered from the second evacuation hole in position.

Optionally, a width of the second evacuation hole is less than a width of the first evacuation hole.

Optionally, the width of the first evacuation hole is 10 µm-20 µm, and the width of the second evacuation hole is 1 µm-5 µm.

Optionally, the first region is further formed with a fourth cavity in communication with the first evacuation hole, where the first evacuation hole is located between the third cavity and the fourth cavity.

Optionally, the MEMS device further includes:
a first bonding ring, formed on the second surface of the first substrate; and
a second bonding ring, formed on the first surface of the second substrate, where the second surface of the first substrate is bonded to the first surface of the second substrate through the first bonding ring and the second bonding ring.

Optionally, the first MEMS structure includes a comb structure of a gyroscope, and the second MEMS structure includes a comb structure of an accelerometer.

Compared with related art, the technical solution of the present invention has the following beneficial effects:
1. In the method for manufacturing a MEMS device according to the present invention, a sacrificial layer and a protective layer that cover a first surface of a first substrate are sequentially formed. A second surface of the first substrate is etched, to form a first cavity and a first evacuation hole in a first region and a second cavity in a second region, where the first evacuation hole exposes the sacrificial layer. After the second surface of the first substrate is bonded to a first surface of a second substrate, multiple second evacuation holes are formed in the protective layer. A third cavity in communication with the second evacuation holes and the first evacuation hole is formed in the first sacrificial layer. The first cavity is evacuated through the second evacuation holes, the third cavity, and the first evacuation hole, and a metal layer is filled in the second evacuation hole. In the present invention, the evacuation hole can be sealed with no need of a laser sealing process, to solve the problem existing in sealing of the large-size evacuation hole, with a reduced cost.
2. The MEMS device of the present invention includes a second substrate, where the second substrate is formed with a first MEMS structure and a second MEMS structure on a first surface; and a first substrate, where a second surface of the first substrate is bonded to the first surface of the second substrate. The first substrate includes a first region corresponding to the first MEMS structure and a second region corresponding to the second MEMS structure, the first region is formed with a first cavity and a first evacuation hole, and the second region is formed with a second cavity. The first surface of the first substrate is covered with a first sacrificial layer and a protective layer, where the protective layer covers the first sacrificial layer. A third cavity is formed in the first sacrificial layer, multiple second evacuation holes are formed in the protective layer, the first evacuation hole is in communication with the first cavity and the third cavity respectively, and the third cavity is in communication with the second evacuation hole. The second evacuation hole is filled with a metal layer. In the present invention, the evacuation hole can be sealed with no need of a laser sealing process, to solve the problem existing in sealing of the large-size evacuation hole, with a reduced cost.

### BRIEF DESCRIPTION OF THE DRAWINGS

Fig. 1 is a schematic cross-sectional view of a MEMS device;
Fig. 2 is a flowchart of a method for manufacturing a MEMS device according to an embodiment of the present invention; and
Figs. 3a-3k are schematic cross-sectional views of a device in the method for manufacturing a MEMS device shown in Fig. 2.

Reference numerals in Figs. 1-3k:
11-first substrate; 12-second substrate; 121-evacuation hole; 21-first substrate; 211-first cavity; 212-second cavity; 213-first evacuation hole; 214-fourth cavity; 22-first sacrificial layer; 221-third cavity; 23-protective layer; 231-second evacuation hole; 24-first bonding ring; 25-gas absorption layer; 31-second substrate; 311-semiconductor substrate; 312-first insulating dielectric layer; 313-electrically conductive structure; 314-second sacrificial layer; 3141-fifth cavity; 315-semiconductor layer; 3151-release hole; 316-second insulating dielectric layer; 32-second bonding ring; 41-metal layer.

### DETAILED DESCRIPTION

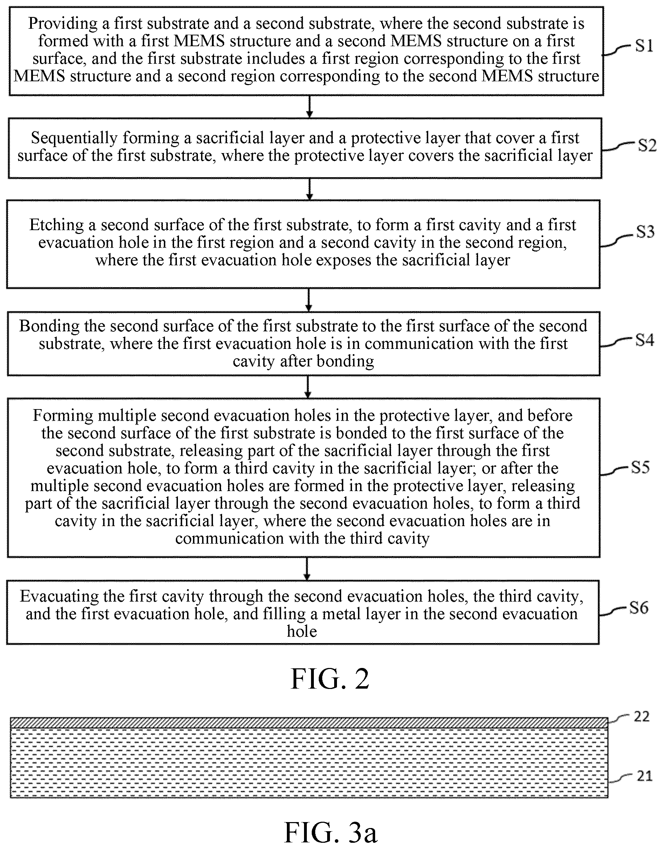

An embodiment of the present invention provides a method for manufacturing a MEMS device. Fig. 2 is a flowchart of a method for manufacturing a MEMS device according to an embodiment of the present invention. The method for manufacturing a MEMS device includes:
Step S1: A first substrate and a second substrate are provided, where the second substrate is formed with a first MEMS structure and a second MEMS structure on a first surface, and the first substrate includes a first region corresponding to the first MEMS structure and a second region corresponding to the second MEMS structure.
Step S2: A sacrificial layer and a protective layer that cover a first surface of the first substrate are sequentially formed, where the protective layer covers the sacrificial layer.
Step S3: A second surface of the first substrate is etched, to form a first cavity and a first evacuation hole in a first region and a second cavity in a second region, where the first evacuation hole exposes the sacrificial layer.
Step S4: The second surface of the first substrate is bonded to the first surface of the second substrate, where the first evacuation hole is in communication with the first cavity after bonding.
Step S5: Multiple second evacuation holes are formed in the protective layer; before the second surface of the first substrate is bonded to the first surface of the second substrate, part of the sacrificial layer is released through the first evacuation hole, to form a third cavity in the sacrificial layer; or after the multiple second evacuation holes are formed in the protective layer, part of the sacrificial layer is released through the second evacuation holes, to form a third cavity in the sacrificial layer, where the second evacuation holes are in communication with the third cavity.
Step S6: The first cavity is evacuated through the second evacuation holes, the third cavity, and the first evacuation hole, and a metal layer is filled in the second evacuation hole.

The method for manufacturing a MEMS device provided in this embodiment will be described in further detail with reference to Figs. 3a-3k. Figs. 3a-3k are schematic views of a device in the method for manufacturing a MEMS device shown in Fig. 2. Figs. 3a-3k are also schematic vertical cross-sectional views of the MEMS device.

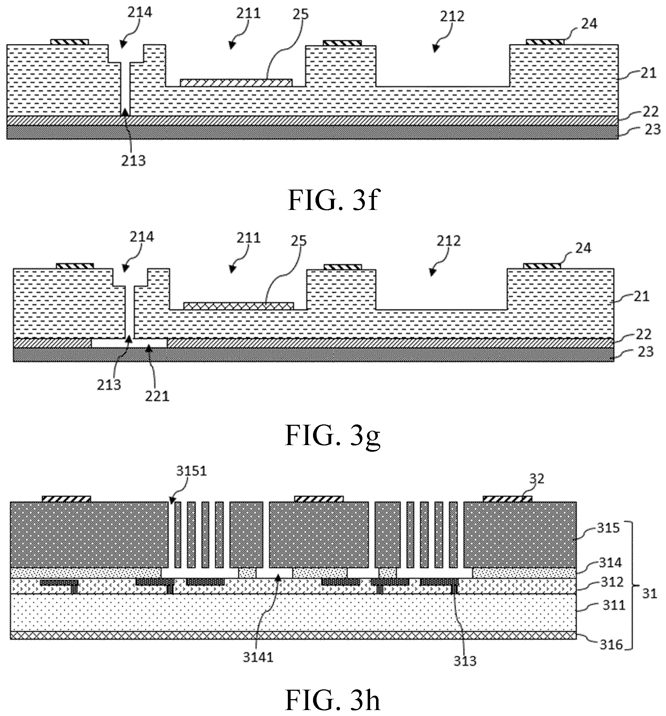

According to Step S1 and referring to Figs. 3a and 3h, a first substrate 21 and a second substrate 31 are provided, where the second substrate 31 is formed with a first MEMS structure and a second MEMS structure on a first surface; and the first substrate 21 includes a first region corresponding to the first MEMS structure and a second region corresponding to the second MEMS structure.

The first substrate 21 may be simply a semiconductor substrate or a wafer containing a semiconductor substrate, and a device structure such as a transistor may be formed in the first substrate 21 as required.

The semiconductor substrate is preferably a double-side polished wafer, so that the performance of the structure fabricated in the first substrate 21 is better.

The first MEMS structure and the second MEMS structure may each include a comb structure and a mass block.

As shown in Fig. 3h, the second substrate 31 may include a semiconductor substrate 311 and a first insulating dielectric layer 312 covering a first surface of the semiconductor substrate 311. An electrically conductive structure 313 connected to the semiconductor substrate 311 is formed in the first insulating dielectric layer 312, and the electrically conductive structure 313 is exposed out of the first insulating dielectric layer 312. A device structure, including a transistor, may also be formed in the semiconductor substrate 311 and the first insulating dielectric layer 312.

The second substrate 31 may further include a second sacrificial layer 314 and a semiconductor layer 315 covering the first insulating dielectric layer 312, where the semiconductor layer 315 covers the second sacrificial layer 314. A fifth cavity 3141 is formed in the second sacrificial layer 314, where the fifth cavity 3141 exposes part of the first insulating dielectric layer 312 and part of the electrically conductive structure 313. The comb structure and the mass block of the first MEMS structure and the comb structure and the mass block of the second MEMS structure are formed in the semiconductor layer 315. A release hole 3151 is formed in the comb structure, between the mass block and the comb structure, and between the mass blocks. The release hole 3151 is in communication with the fifth cavity 3141, and the fifth cavity 3141 is used for providing a vibration space for the comb structure and the mass block.

In addition, the second substrate 31 may further include a second insulating dielectric layer 316 covering a second surface of the semiconductor substrate 311, such that the second surface of the semiconductor substrate 311 is insulated from other structures.

As shown in Fig. 3h, before a second surface of the first substrate 21 is subsequently bonded to the first surface of the second substrate 31, the method for manufacturing a MEMS device further includes: forming a second bonding ring 32 on the first surface of the second substrate 31. The second bonding ring 32 can be formed after the semiconductor layer 315 is formed and before the release hole 3151 is formed, and the second bonding ring 32 is formed on the semiconductor layer 315.

The step of forming the second bonding ring 32 on the first surface of the second substrate 31 includes: forming a metal material on the first surface of the second substrate 31 by sputtering or evaporation; then forming a patterned mask layer (not shown) on the metal material; and next, etching the metal material with the patterned mask layer as a mask, to form the second bonding ring 32; and then, removing the patterned mask layer.

The material of the semiconductor substrate may include Si, Ge, SiGe, SiC, SiGeC, InAs, GaAs, InP, InGaAs or other III/V compound semiconductors, or include a multi-layer structure formed of these semiconductors. Alternatively, the semiconductor substrate may be silicon on insulator (SOI), strained silicon on insulator (SSOI), strained silicon-germanium on insulator (S-SiGeOI), silicon germanium on insulator (SiGeOI), germanium on insulator (GeOI), and the like. Choice can be made by those skilled in the art according to needs.

The material of the semiconductor layer 315 may include Si, Ge, SiGe, SiC, SiGeC, InAs, GaAs, InP, InGaAs or other III/V compound semiconductors, or include a multi-layer structure formed of these semiconductors.

The materials of the first insulating dielectric layer 312 and the second insulating dielectric layer 316 may be at least one of insulating materials such as silicon oxide, silicon oxynitride and silicon nitride, and the first insulating dielectric layer 312 may have a stacked structure of at least two layers.

The material of the electrically conductive structure 313 may be polysilicon or a metal.

The material of the second sacrificial layer 314 includes, but is not limited to, silicon oxide.

The material of the second bonding ring 32 may include metal materials such as germanium, aluminum, copper, nickel or gold.

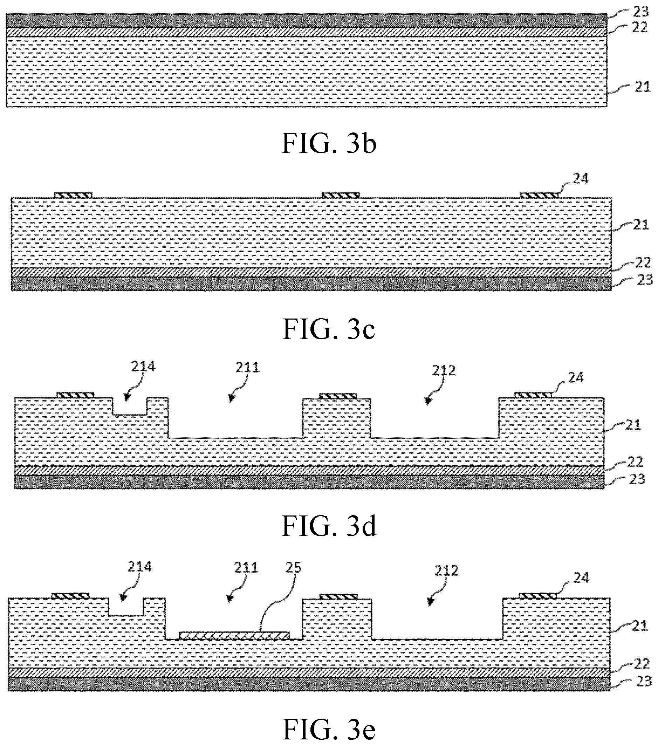

According to Step S2 and referring to Figs. 3a and 3b, a first sacrificial layer 22 and a protective layer 23 that cover a first surface of the first substrate 21 are sequentially formed, where the protective layer 23 covers the first sacrificial layer 22.

The protective layer 23 is used to protect the first sacrificial layer 22, to prevent the first sacrificial layer 22 from being corroded by a cleaning process in a subsequent process.

The etching rates of the first sacrificial layer 22 and the protective layer 23 are quite different. For example, the etching selectivity ratio of the first sacrificial layer 22 to the protective layer 23 is greater than 10, so that when the first sacrificial layer 22 is etched later, the protective layer 23 is not etched or the protective layer 23 is only etched lowly.

The material of the first sacrificial layer 22 includes, but is not limited to, silicon oxide.

The material of the protective layer 23 may be silicon nitride, polysilicon or monocrystalline silicon.

In addition, referring to Fig. 3c, before the second surface of the first substrate 21 is etched, the method for manufacturing a MEMS device further includes: forming a first bonding ring 24 on the second surface of the first substrate 21.

The step of forming the first bonding ring 24 on the second surface of the first substrate 21 may include: forming a metal material on the second surface of the first substrate 21 by sputtering or evaporation; then, forming a patterned mask layer (not shown) on the metal material; next, etching the metal material with the patterned mask layer as a mask, to form the first bonding ring 24; and then, removing the patterned mask layer. When the first bonding ring 24 is formed, a structure such as a pad can also be formed on the second surface of the first substrate 21.

The material of the first bonding ring 24 may include metal materials such as germanium, aluminum, copper, nickel or gold.

The first surface is a front surface, and the second surface is a back surface. Alternatively, the first surface is a back surface, and the second surface is a front surface.

According to Step S3 and referring to Figs. 3d-3f, the second surface of the first substrate 21 is etched, to form a first cavity 211 and a first evacuation hole 213 in the first region and a second cavity 212 in the second region, where the first evacuation hole 213 exposes the first sacrificial layer 22.

In an embodiment, the first region may also be formed with a fourth cavity 214.

The step of forming the first cavity 211, the first evacuation hole 213 and the fourth cavity 214 in the first region and the second cavity 212 in the second region may include: as shown in Fig. 3d, etching the second surface of the first substrate 21, to form the first cavity 211 and the fourth cavity 214 in the first region and the second cavity 212 in the second region; and then, as shown in Fig. 3f, etching a bottom wall of the fourth cavity 214 until reaching the first sacrificial layer 22, to form the first evacuation hole 213 in the bottom wall of the fourth cavity 214.

Because the etching process is only applicable to the etching of the first evacuation hole 213 having a depth-to-width ratio that meets a certain requirement, when the depth-to-width ratio of the first evacuation hole 213 is too high, it cannot be etched by the etching process. Therefore, when the thickness of the first substrate 21 is large, it is preferable to etch the second surface of the first substrate 21 to form the fourth cavity 214, and then etch the bottom wall of the fourth cavity 214 to form the first evacuation hole 213. That is, the first substrate 21 is etched through in two steps to expose the first sacrificial layer 22. It is to be understood that even if the first substrate 21 is etched through in two steps, the width of the formed first evacuation hole 213 is still large.

Both the fourth cavity 214 and the first evacuation hole 213 are used for evacuation. The width of the fourth cavity 214 is greater than the width of the first evacuation hole 213. The first cavity 211 and the second cavity 212 are respectively used to provide a vibration space for the first MEMS structure and the second MEMS structure after subsequent bonding. The width and depth of the fourth cavity 214 are both less than those of the first cavity 211 and the second cavity 212. The sequence of forming the fourth cavity 214, the first cavity 211 and the second cavity 212 is not limited, and they may be formed at the same or different times.

In addition, as shown in Fig. 3e, after the first cavity 211 is formed and before the first evacuation hole 213 is formed, the method for manufacturing a MEMS device further includes: forming a gas absorption layer 25 on a bottom wall of the first cavity 211, where the gas absorption layer 25 is used for absorbing gas, to improve the vacuum level in the MEMS device. The material of the gas absorption layer 25 may be a metal material.

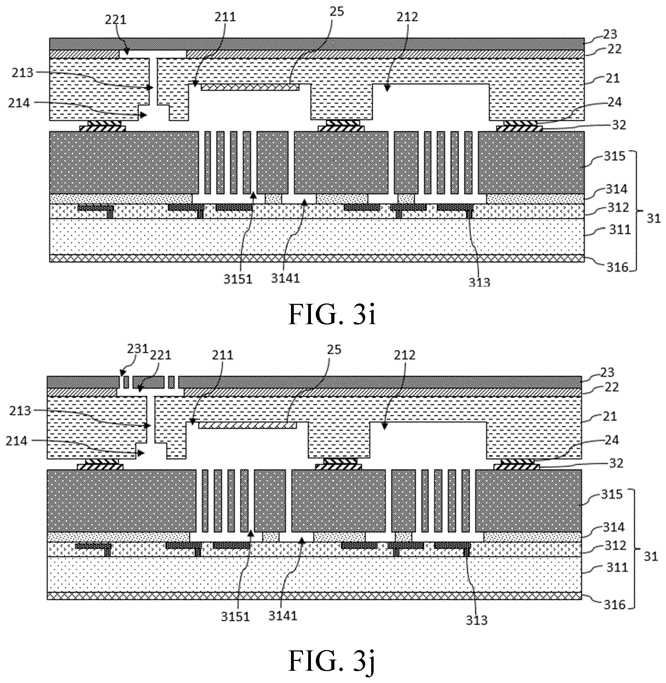

According to Step S4 and referring to Fig. 3i, the second surface of the first substrate 21 is bonded to the first surface of the second substrate 31. After bonding, the fourth cavity 214 and the first evacuation hole 213 are in communication with the first cavity 211.

In addition, after bonding, the first cavity 211 is aligned with the first MEMS structure, the second cavity 212 is aligned with the second MEMS structure, and there is no communication between the first cavity 211 and the second cavity 212, so that a first MEMS device corresponding to the first cavity 211 and the first MEMS structure and a second MEMS device corresponding to the second cavity 212 and the second MEMS structure are formed on the same substrate.

The bonding of the second surface of the first substrate 21 to the first surface of the second substrate 31 includes: bonding the second surface of the first substrate 21 to the first surface of the second substrate 31 through the first bonding ring 24 and the second bonding ring 32.

The first bonding ring 24 and the second bonding ring 32 are both of a ring structure. The dimensions of the first bonding ring 24 and the second bonding ring 32 may be the same or nearly the same. The first bonding ring 24 and the second bonding ring 32 may be eutectically bonded.

During bonding, the second surface of the first substrate 21 is opposite to the first surface of the second substrate 31, and the first bonding ring 24 is aligned with the second bonding ring 32; and a pressure is applied, so that the first bonding ring 24 and the second bonding ring 32 are bonded under a set condition after being in contact with each other, to form a metal block, and the first substrate 21 and the second substrate 31 are closer in distance. When the materials of the first bonding ring 24 and the second bonding ring 32 are different (for example, the material of the first bonding ring 24 is aluminum and the material of the second bonding ring 32 is germanium), the metal block is an alloy.

In addition, during bonding, a vacuum level required in the second MEMS device corresponding to the second cavity 212 can be used in a vacuum pressure-control process. In this case, the vacuum level in the second MEMS device corresponding to the second cavity 212 is the same as that in the first MEMS device corresponding to the first cavity 211.

According to Step S5 and referring to Fig. 3j, the protective layer 23 is etched, to form multiple second evacuation holes 231 in the protective layer 23.

In addition, referring to Fig. 3g, before the second surface of the first substrate 21 is bonded to the first surface of the second substrate 31, part of the first sacrificial layer 22 is released through the fourth cavity 214 and the first evacuation hole 213, to form the third cavity 221 in the first sacrificial layer 22. Alternatively, after the multiple second evacuation holes 231 are formed in the protective layer 23, part of the first sacrificial layer 22 is released through the second evacuation holes 231, to form the third cavity 221 in the first sacrificial layer 22.

The second evacuation hole 231 is in communication with the third cavity 221, the third cavity 221 exposes the protective layer 23, and the width of the third cavity 221 is greater than the width of the first evacuation hole 213.

Part of the first sacrificial layer 22 can be released through a vapor HF (VHF) etching process. That is, vapor hydrofluoric acid is introduced into the fourth cavity 214 and the first evacuation hole 213 to etch and remove part of the first sacrificial layer 22 through the fourth cavity 214 and the first evacuation hole 213. Alternatively, gaseous hydrofluoric acid is introduced into the second evacuation hole 231, to etch and remove part of the first sacrificial layer 22 through the second evacuation hole 231.

Preferably, the first evacuation hole 213 is staggered from the second evacuation hole 231 in position. When a metal layer 41 is subsequently filled into the second evacuation hole 231, the metal particles will fall down through the second evacuation hole 231. By staggering the first evacuation hole 213 from the second evacuation hole 231 in position, the metal particles can be prevented from falling into the first evacuation hole 213, thereby preventing the metal particles from falling into the device through the first evacuation hole 213 and affecting the device performance.

The metal particles will fall and accumulate in the third cavity 221 below the second evacuation hole 231. The first evacuation hole 213 may be aligned with a center area of the third cavity 221, and the second evacuation hole 231 may be aligned with a marginal area of the third cavity 221, so that the metal particles will fall and accumulate in the marginal area of the third cavity 221.

Preferably, the width of the second evacuation hole 231 is less than the width of the first evacuation hole 213, whereby the metal layer 41 can be quickly filled in the second evacuation hole 231 subsequently, that is, the hole is quickly sealed.

Further preferably, the width of the first evacuation hole 213 is 10 µm-20 µm, and the width of the second evacuation hole 231 is 1 µm-5 µm.

Because the etching process is only applicable to the etching of the first evacuation hole 213 having a depth-to-width ratio that meets a certain requirement, when the depth-to-width ratio of the first evacuation hole 213 is too high, it cannot be etched by the etching process. Therefore, when the thickness of the first substrate 21 is large, the width of the first evacuation hole 213 formed by etching the first substrate 21 is also large. At this time, if a laser sealing process is directly used, the sealing of the first evacuation hole 213 has a poor effect or even impossible. In addition, a special machine used for the laser sealing process is expensive, and the sealing efficiency is low due to one-by-one sealing of the first evacuation hole 213 during operation, leading to a very high cost. Therefore, in the method for manufacturing a MEMS device provided in the present invention, the second evacuation hole 231 in communication with the first evacuation hole 213 is formed in the protective layer 23, and then the second evacuation hole 231 is filled with the metal layer 41 to seal the hole. In this way, the evacuation hole can be sealed with no need of the laser sealing process. In addition, compared with the sealing of a hole by the laser sealing process, the problem that the sealing of the first evacuation hole 213 with a large width by the laser sealing process has a poor effect or even impossible can be solved by the method for manufacturing a MEMS device provided in the present invention, and the second evacuation hole 231 with any width can be sealed by the method for manufacturing a MEMS device, with a better sealing effect. In addition, the hole sealing can be realized by using a conventional deposition machine without using an expensive special machine, and all the second evacuation holes 231 can be sealed simultaneously, so that the hole sealing efficiency is obviously improved, and the cost is further reduced.

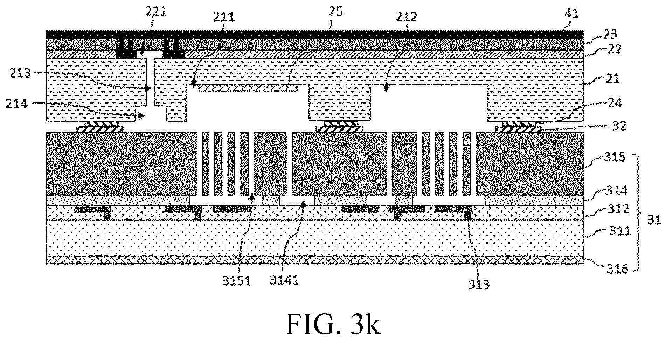

According to Step S6 and referring to Fig. 3k, the first cavity 211 is evacuated through the second evacuation hole 231, the third cavity 221, and the first evacuation hole 213, to reach a vacuum level required in the first MEMS device corresponding to the first cavity 211; and the metal layer 41 is filled in the second evacuation hole 231, to seal the second evacuation hole 231. In this manner, the second evacuation hole 231 is sealed, and thus the third cavity 221, the first evacuation hole 213, the fourth cavity 214 and the first cavity 211 are sealed.

The metal layer 41 can be deposited in the second evacuation hole 231 by a process such as physical vapor deposition or evaporation that puts forward a requirement for the vacuum level. Before the physical vapor deposition or evaporation process is performed, the chamber is vacuumized. In this step, since the first cavity 211 is in communication with the outside through the second evacuation hole 231, the third cavity 221 and the first evacuation hole 213, the gas in the first cavity 211 can be extracted during the vacuumizing process, so that the vacuum level in the first cavity 211 can meet the requirement of the first MEMS device. However, the second cavity 212 is not in communication with the outside, so that the vacuumizing step has no influence on the vacuum level in the second cavity 212, and the vacuum level in the second cavity 212 remains to be the vacuum level during the bonding process. Therefore, the first MEMS device and the second MEMS device formed on the same substrate can have different vacuum levels. After that, the process of depositing the metal layer 41 is also carried out in the same vacuum chamber, so that after the metal layer 41 is deposited, the first cavity 211 still maintains a required vacuum level.

In addition, the process temperature for depositing the metal layer 41 in the second evacuation hole 231 by physical vapor deposition is in the range of 400°C-500°C, and the process temperature for depositing the metal layer 41 in the second evacuation hole 231 by evaporation is normal temperature. Compared with the process temperature that is a high temperature of 700°C-800°C used in depositing an insulating material in the second evacuation hole 231 by chemical vapor deposition, the process temperature for depositing the metal layer 41 by physical vapor deposition and evaporation is lower, whereby the metal block formed by the bonding reaction between the first bonding ring 24 and the second bonding ring 32 can be prevented from being melted at a high temperature during the sealing process, thereby avoiding the abnormal bonding.

The first MEMS device may be a gyroscope, and the second MEMS device may be an accelerometer. The first MEMS structure may include a comb structure and a mass block of the gyroscope, and the second MEMS structure may include a comb structure and a mass block of the accelerometer. Alternatively, the first MEMS device may be an accelerometer, and the second MEMS device may be a gyroscope. The first MEMS structure may include a comb structure and a mass block of the accelerometer, and the second MEMS structure may include a comb structure and a mass block of the gyroscope.

Based on the above disclosure, in the method for manufacturing a MEMS device according to the present invention, a first sacrificial layer and a protective layer that cover the first surface of the first substrate are sequentially formed. The second surface of the first substrate is etched, to form a first cavity and a first evacuation hole in the first region and a second cavity in the second region, where the first evacuation hole exposes the first sacrificial layer. After the second surface of the first substrate is bonded to the first surface of the second substrate, multiple second evacuation holes are formed in the protective layer, and a third cavity in communication with the second evacuation holes and the first evacuation hole is formed in the first sacrificial layer. The first cavity is evacuated through the second evacuation holes, the third cavity, and the first evacuation hole, and a metal layer is filled in the second evacuation hole. In this way, the evacuation hole can be sealed with no need of a laser sealing process, to solve the problem existing in sealing of the large-size evacuation hole, with a reduced cost.

An embodiment of the present invention provides a MEMS device, which includes: a second substrate, where the second substrate is formed with a first MEMS structure and a second MEMS structure on a first surface; and a first substrate, where a second surface of the first substrate is bonded to the first surface of the second substrate. The first substrate includes a first region corresponding to the first MEMS structure and a second region corresponding to the second MEMS structure, the first region is formed with a first cavity and a first evacuation hole, and the second region is formed with a second cavity. A first surface of the first substrate is covered with a sacrificial layer and a protective layer, where the protective layer covers the sacrificial layer. A third cavity is formed in the sacrificial layer, multiple second evacuation holes are formed in the protective layer, the first evacuation hole is in communication with the first cavity and the third cavity respectively, and the third cavity is in communication with the second evacuation hole. The second evacuation hole is filled with a metal layer.

The MEMS device in this embodiment will be described in further detail with reference to Fig. 3k. Fig. 3k is a schematic vertical cross-sectional view of the MEMS device.

The second substrate 31 is formed with a first MEMS structure and a second MEMS structure on a first surface.

The first MEMS structure and the second MEMS structure may each include a comb structure and a mass block.

The second substrate 31 may include a semiconductor substrate 311 and a first insulating dielectric layer 312 covering a first surface of the semiconductor substrate 311. An electrically conductive structure 313 connected to the semiconductor substrate 311 is formed in the first insulating dielectric layer 312, and the electrically conductive structure 313 is exposed out of the first insulating dielectric layer 312. A device structure, including a transistor, may also be formed in the semiconductor substrate 311 and the first insulating dielectric layer 312.

The second substrate 31 may further include a second sacrificial layer 314 and a semiconductor layer 315 covering the first insulating dielectric layer 312, where the semiconductor layer 315 covers the second sacrificial layer 314. A fifth cavity 3141 is formed in the second sacrificial layer 314, where the fifth cavity 3141 exposes part of the first insulating dielectric layer 312 and part of the electrically conductive structure 313. The comb structure and the mass block of the first MEMS structure and the comb structure and the mass block of the second MEMS structure are formed in the semiconductor layer 315. A release hole 3151 is formed in the comb structure, between the mass block and the comb structure, and between the mass blocks. The release hole 3151 is in communication with the fifth cavity 3141, and the fifth cavity 3141 is used for providing a vibration space for the comb structure and the mass block.

In addition, the second substrate 31 may further include a second insulating dielectric layer 316 covering a second surface of the semiconductor substrate 311, such that the second surface of the semiconductor substrate 311 is insulated from other structures.

A second surface of the first substrate 21 is bonded to the first surface of the second substrate 31. The first substrate 21 includes a first region corresponding to the first MEMS structure and a second region corresponding to the second MEMS structure.

The first substrate 21 may be simply a semiconductor substrate or a wafer containing a semiconductor substrate, and a device structure such as a transistor may be formed in the first substrate 21 as required.

The semiconductor substrate is preferably a double-side polished wafer, so that the performance of the structure fabricated in the first substrate 21 is better.

The material of the semiconductor substrate may include Si, Ge, SiGe, SiC, SiGeC, InAs, GaAs, InP, InGaAs or other III/V compound semiconductors, or include a multi-layer structure formed of these semiconductors. Alternatively, the semiconductor substrate may be silicon on insulator (SOI), strained silicon on insulator (SSOI), strained silicon-germanium on insulator (S-SiGeOI), silicon germanium on insulator (SiGeOI), germanium on insulator (GeOI), and the like. Choice can be made by those skilled in the art according to needs.

The material of the semiconductor layer 315 may include Si, Ge, SiGe, SiC, SiGeC, InAs, GaAs, InP, InGaAs or other III/V compound semiconductors, or include a multi-layer structure formed of these semiconductors.

The materials of the first insulating dielectric layer 312 and the second insulating dielectric layer 316 may be at least one of insulating materials such as silicon oxide, silicon oxynitride and silicon nitride, and the first insulating dielectric layer 312 may have a stacked structure of at least two layers.

The material of the electrically conductive structure 313 may be polysilicon or a metal.

The material of the second sacrificial layer 314 includes, but is not limited to, silicon oxide.

The first region is formed with a first cavity 211 and a first evacuation hole 213, and the second region is formed with a second cavity 212.

The first cavity 211 is aligned with the first MEMS structure, and the second cavity 212 is aligned with the second MEMS structure. The first cavity 211 and the second cavity 212 are respectively used to provide a vibration space for the first MEMS structure and the second MEMS structure. There is no communication between the first cavity 211 and the second cavity 212, so that a first MEMS device corresponding to the first cavity 211 and the first MEMS structure and a second MEMS device corresponding to the second cavity 212 and the second MEMS structure are formed on the same substrate.

The first surface of the first substrate 21 is covered with a first sacrificial layer 22 and a protective layer 23, where the protective layer 23 covers the first sacrificial layer 22. The first sacrificial layer 22 is formed with a third cavity 221, and the protective layer 23 is formed with multiple second evacuation holes (that, the second evacuation holes 231 in Fig. 3j). The first evacuation hole 213 is in communication with the first cavity 211 and the third cavity 221 respectively, and the third cavity 221 is in communication with the second evacuation hole 231. The width of the third cavity 221 is greater than the width of the first evacuation hole 213. The second evacuation hole 231 is filled with a metal layer 41 therein.

The first surface is a front surface, and the second surface is a back surface. Alternatively, the first surface is a back surface, and the second surface is a front surface.

The protective layer 23 is used to protect the first sacrificial layer 22, to prevent the first sacrificial layer 22 from being corroded by a cleaning process.

The etching rates of the first sacrificial layer 22 and the protective layer 23 are quite different. For example, the etching selectivity ratio of the first sacrificial layer 22 to the protective layer 23 is greater than 10, so that when the first sacrificial layer 22 is etched to form the third cavity 221, the protective layer 23 is not etched or the protective layer 23 is only etched lowly.

The material of the first sacrificial layer 22 includes, but is not limited to, silicon oxide.

The material of the protective layer 23 may be silicon nitride, polysilicon or monocrystalline silicon.

The first region may be further formed with a fourth cavity 214 in communication with the first evacuation hole 213, where the first evacuation hole 213 is located between the third cavity 221 and the fourth cavity 214, and the fourth cavity 214 is in communication with the first cavity 211.

The width of the fourth cavity 214 is greater than the width of the first evacuation hole 213. The width and depth of the fourth cavity 214 are both less than those of the first cavity 211 and the second cavity 212.

The MEMS device may further include: a gas absorption layer 25, formed on a bottom wall of the first cavity 211, where the gas absorption layer 25 is used for absorbing gas, to improve the vacuum level in the MEMS device. The material of the gas absorption layer 25 may be a metal material.

Preferably, the first evacuation hole 213 is staggered from the second evacuation hole 231 in position. When the metal layer 41 is filled into the second evacuation hole 231, the metal particles will fall down through the second evacuation hole 231. By staggering the first evacuation hole 213 from the second evacuation hole 231 in position, the metal particles can be prevented from falling into the first evacuation hole 213, thereby preventing the metal particles from falling into the device through the first evacuation hole 213 and affecting the device performance.

The metal particles will fall and accumulate in the third cavity 221 below the second evacuation hole 231. The first evacuation hole 213 may be aligned with a center area of the third cavity 221, and the second evacuation hole 231 may be aligned with a marginal area of the third cavity 221, so that the metal particles will fall and accumulate in the marginal area of the third cavity 221.

Preferably, the width of the second evacuation hole 231 is less than the width of the first evacuation hole 213, whereby the metal layer 41 can be quickly filled in the second evacuation hole 231. That is, the hole is quickly sealed.

Further preferably, the width of the first evacuation hole 213 is 10 µm-20 µm, and the width of the second evacuation hole 231 is 1 µm-5 µm.

Since the first cavity 211 is in communication with the second evacuation hole 231, the third cavity 221 and the first evacuation hole 213, the first cavity 211 can be evacuated through the second evacuation hole 231, the third cavity 221, and the first evacuation hole 213, to reach a vacuum level required in the first MEMS device corresponding to the first cavity 211. In addition, by filling the metal layer 41 in the second evacuation hole 231, the second evacuation hole 231 can be sealed, whereby the third cavity 221, the first evacuation hole 213, the fourth cavity 214 and the first cavity 211 in communication with the second evacuation hole 231 are sealed.

The MEMS device further includes:
a first bonding ring 24, formed on the second surface of the first substrate 21; and
a second bonding ring 32, formed on the first surface of the second substrate 31, where the second surface the first substrate 21 is bonded to the first surface of the second substrate 31 through the first bonding ring 24 and the second bonding ring 32.

The material of the second bonding ring 32 may include metal materials such as germanium, aluminum, copper, nickel or gold.

The first bonding ring 24 and the second bonding ring 32 are both of a ring structure. The dimensions of the first bonding ring 24 and the second bonding ring 32 may be the same or nearly the same. The first bonding ring 24 and the second bonding ring 32 may be eutectically bonded.

During the bonding, the second surface of the first substrate 21 is opposite to the first surface of the second substrate 31, and the first bonding ring 24 is aligned with the second bonding ring 32; and a pressure is applied, so that the first bonding ring 24 and the second bonding ring 32 are bonded under a set condition after being in contact with each other, to form a metal block, and the first substrate 21 and the second substrate 31 are closer in distance. When the materials of the first bonding ring 24 and the second bonding ring 32 are different (for example, the material of the first bonding ring 24 is aluminum and the material of the second bonding ring 32 is germanium), the metal block is an alloy.

In addition, during the bonding, a vacuum level required in the second MEMS device corresponding to the second cavity 212 can be used. In this case, the vacuum level in the second MEMS device corresponding to the second cavity 212 is the same as that in the first MEMS device corresponding to the first cavity 211.

Since the first cavity 211 is in communication with the outside through the second evacuation hole 231, the third cavity 221 and the first evacuation hole 213, the gas in the first cavity 211 can be extracted, so that the vacuum level in the first cavity 211 can meet the requirement of the first MEMS device. However, since the second cavity 212 is not in communication with the outside, the vacuum level in the second cavity 212 will not be affected when the first cavity 211 is evacuated, and the vacuum level in the second cavity 212 remains to be the vacuum level during the bonding process. Therefore, the first MEMS device and the second MEMS device formed on the same substrate can have different vacuum levels. In addition, the process of filling the metal layer 41 is also carried out in the same vacuum chamber, so that after the metal layer 41 is filled, the first cavity 211 still maintains a required vacuum level.

The first MEMS device may be a gyroscope, and the second MEMS device may be an accelerometer. The first MEMS structure may include a comb structure and a mass block of the gyroscope, and the second MEMS structure may include a comb structure and a mass block of the accelerometer. Alternatively, the first MEMS device may be an accelerometer, and the second MEMS device may be a gyroscope. The first MEMS structure may include a comb structure and a mass block of the accelerometer, and the second MEMS structure may include a comb structure and a mass block of the gyroscope.

Because the etching process is only applicable to the etching of the first evacuation hole 213 having a depth-to-width ratio that meets a certain requirement, when the depth-to-width ratio of the first evacuation hole 213 is too high, it cannot be etched by the etching process. Therefore, when the thickness of the first substrate 21 is large, the width of the first evacuation hole 213 formed by etching the first substrate 21 is also large. At this time, if a laser sealing process is directly used, the sealing of the first evacuation hole 213 has a poor effect or even impossible. In addition, a special machine used for the laser sealing process is expensive, and the sealing efficiency is low due to one-by-one sealing of the first evacuation hole 213 during operation, leading to a very high cost. Therefore, in the MEMS device provided in the present invention, the second evacuation hole 231 in communication with the first evacuation hole 213 is formed in the protective layer 23, and the second evacuation hole 231 is sealed by filling with the metal layer 41 therein. In this way, the evacuation hole can be sealed with no need of the laser sealing process. In addition, compared with the sealing of a hole by the laser sealing process, the problem that the sealing of the first evacuation hole 213 with a large width by the laser sealing process has a poor effect or even impossible can be solved by the MEMS device provided in the present invention, and the second evacuation hole 231 with any width in the MEMS device can be sealed with a better sealing effect. **In** addition, the hole sealing can be realized by using a conventional deposition machine without using an expensive special machine, and all the second evacuation holes 231 can be sealed simultaneously, so that the hole sealing efficiency is obviously improved, and the cost is further reduced.

Based on the above disclosure, the MEMS device of the present invention includes a second substrate, where the second substrate is formed with a first MEMS structure and a second MEMS structure on a first surface; and a first substrate, where a second surface of the first substrate is bonded to the first surface of the second substrate. The first substrate includes a first region corresponding to the first MEMS structure and a second region corresponding to the second MEMS structure, the first region is formed with a first cavity and a first evacuation hole, and the second region is formed with a second cavity. The first surface of the first substrate is covered with a first sacrificial layer and a protective layer, where the protective layer covers the first sacrificial layer. A third cavity is formed in the first sacrificial layer, multiple second evacuation holes are formed in the protective layer, the first evacuation hole is in communication with the first cavity and the third cavity respectively, and the third cavity is in communication with the second evacuation hole. The second evacuation hole is filled with a metal layer. In the present invention, the evacuation hole can be sealed with no need of a laser sealing process, to solve the problem existing in sealing of the large-size evacuation hole, with a reduced cost.

Preferred embodiments of the present invention have been described in detail above, which do not constitute any restriction on the present invention. Any changes and modifications made by those of ordinary skill in the art to which the present invention pertains according to the above disclosure are all embraced in the scope of protection of the claims.

## Claims

1. A method for manufacturing a MEMS device, comprising:
providing a first substrate and a second substrate, wherein the second substrate is formed with a first MEMS structure and a second MEMS structure on a first surface, and the first substrate comprises a first region corresponding to the first MEMS structure and a second region corresponding to the second MEMS structure;
sequentially forming a sacrificial layer and a protective layer that cover a first surface of the first substrate, wherein the protective layer covers the sacrificial layer;
etching a second surface of the first substrate, to form a first cavity and a first evacuation hole in the first region and a second cavity in the second region, wherein the first evacuation hole exposes the sacrificial layer;
bonding the second surface of the first substrate to the first surface of the second substrate, wherein the first evacuation hole is in communication with the first cavity after bonding;
forming multiple second evacuation holes in the protective layer, and before the second surface of the first substrate is bonded to the first surface of the second substrate, releasing part of the sacrificial layer through the first evacuation hole, to form a third cavity in the sacrificial layer; or after the multiple second evacuation holes are formed in the protective layer, releasing part of the sacrificial layer through the second evacuation holes, to form a third cavity in the sacrificial layer, wherein the second evacuation holes are in communication with the third cavity; and
evacuating the first cavity through the second evacuation holes, the third cavity, and the first evacuation hole, and filling a metal layer in the second evacuation hole.

2. The method for manufacturing a MEMS device according to claim 1, wherein the first evacuation hole is staggered from the second evacuation hole in position.

3. The method for manufacturing a MEMS device according to claim 1, wherein a width of the second evacuation hole is less than a width of the first evacuation hole.

4. The method for manufacturing a MEMS device according to claim 3, wherein the width of the first evacuation hole is 10 µm-20 µm, and the width of the second evacuation hole is 1 µm-5 µm.

5. The method for manufacturing a MEMS device according to claim 1, wherein the first region is further formed with a fourth cavity in communication with the first evacuation hole, and the step of forming the first cavity, the first evacuation hole and the fourth cavity in the first region and forming the second cavity in the second region includes:
etching the second surface of the first substrate, to form the first cavity and the fourth cavity in the first region, and form the second cavity in the second region; and
etching a bottom wall of the fourth cavity, to form the first evacuation hole in the bottom wall of the fourth cavity.

6. The method for manufacturing a MEMS device according to claim 1, wherein before the second surface of the first substrate is etched, the method for manufacturing a MEMS device further comprises:
forming a first bonding ring on the second surface of the first substrate;
before the second surface of the first substrate is bonded to the first surface of the second substrate, the method for manufacturing a MEMS device further comprises:
forming a second bonding ring on the first surface of the second substrate; and
the bonding of the second surface of the first substrate to the first surface of the second substrate comprises: bonding the second surface of the first substrate to the first surface of the second substrate through the first bonding ring and the second bonding ring.

7. The method for manufacturing a MEMS device according to claim 1, wherein the first MEMS structure comprises a comb structure of a gyroscope, and the second MEMS structure comprises a comb structure of an accelerometer.

8. A MEMS device, comprising:
a first substrate and a second substrate, wherein the second substrate is formed with a first MEMS structure and a second MEMS structure on a first surface;
a second surface of the first substrate is bonded to the first surface of the second substrate; the first substrate comprises a first region corresponding to the first MEMS structure and a second region corresponding to the second MEMS structure, the first region is formed with a first cavity and a first evacuation hole, and the second region is formed with a second cavity; a first surface of the first substrate is covered with a sacrificial layer and a protective layer, the protective layer covers the sacrificial layer, a third cavity is formed in the sacrificial layer, multiple second evacuation holes are formed in the protective layer, the first evacuation hole is in communication with the first cavity and the third cavity respectively, and the third cavity is in communication with the second evacuation hole; and the second evacuation hole is filled with a metal layer.

9. The MEMS device according to claim 8, wherein the first evacuation hole is staggered from the second evacuation hole in position.

10. The MEMS device according to claim 8, wherein a width of the second evacuation hole is less than a width of the first evacuation hole.

11. The MEMS device according to claim 10, wherein the width of the first evacuation hole is 10 µm-20 µm, and the width of the second evacuation hole is 1 µm-5 µm.

12. The MEMS device according to claim 8, wherein the first region is further formed with a fourth cavity in communication with the first evacuation hole, and the first evacuation hole is located between the third cavity and the fourth cavity.

13. The MEMS device according to claim 8, further comprising:
a first bonding ring, formed on the second surface of the first substrate; and
a second bonding ring, formed on the first surface of the second substrate, wherein the second surface of the first substrate is bonded to the first surface of the second substrate through the first bonding ring and the second bonding ring.

14. The MEMS device according to claim 8, wherein the first MEMS structure comprises a comb structure of a gyroscope, and the second MEMS structure comprises a comb structure of an accelerometer.

15. The MEMS device according to claim 8, further comprising a gas absorption layer, formed on a bottom wall of the first cavity, wherein the gas absorption layer is used for absorbing gas, to improve a vacuum level in the MEMS device.
